# EUROPEAN PATENT SPECIFICATION

(11) **EP 3 324 449 B1**
(45) Date of publication and mention of the grant of the patent: **16.06.2021**
(21) Application number: 16199811.7
(22) Date of filing: 21.11.2016
(51) Int. Cl.: H01L 31/052

(54) **RECEIVER DEVICE FOR CONCENTRATING PHOTOVOLTAIC SYSTEMS**
EMPFAENGERVORRICHTUNG ZUR KONZENTRATION PHOTOVOLTAISCHER SYSTEME
DISPOSITIF RÉCEPTEUR DE CONCENTRATION DE SYSTÈMES PHOTOVOLTAIQUES

(43) Date of publication of application: 23.05.2018
(73) Proprietor: Solergy Italia S.r.l., 00060 Formello (RM) (IT)
(72) Inventor: Lanzara, Giovanni, 00060 Formello (IT)
(74) Representative: de Simone, Domenico

(56) References cited:
- WO-A1-95/08844
- US-A1- 2010 139 738
- US-A1- 2013 333 746

## Description

### TECHNICAL FIELD

The present invention relates to a receiver device for concentrating photovoltaic (CPV) systems. Also, the invention relates to an optical system and a concentrator device comprising said receiver as well as a concentrating solar photovoltaic system comprising a plurality of said concentrators.

### BACKGROUND

Optical photovoltaic concentrators are used in the CPV technology in order to concentrate the solar light on a surface of reduced dimension. The basic principle of this device is the employment of an optical collector of a reflective (mirror) or refracting (lens) type. In particular, the solar light is concentrated on a receiver comprising one (point focus) or a plurality (dense array) of high efficiency solar cells, which transform the light energy into electrical and/or thermal energy.

A CPV system basically comprises three components: a focusing optics (lens or mirrors) for concentrating the light, a receiver (PV cell, electrical connectors, heat spreader,...) for converting the received solar light, and a tracking apparatus (uniaxial or biaxial) for tracking the movement of the sun and aligning the incident solar rays to the focusing optics.

There exist several types of CPV systems based on the different focusing method and the different receiver device. Usually, multijunction solar cells are used in CPV systems due to their higher energy conversion efficiency compared to the standard silicon solar cells. However, in order to realize a reliable multijunction solar cell for CPV system, several factors must be taken into account, such as the lattice constant and the crystalline structure of the semiconductor material employed as well as their thermal expansion coefficient. It is worth to emphasize that the electrical performance of the solar cells drastically decreases with increasing the cell operating temperature, the temperature strongly affecting the open circuit voltage of the cell. Given a determinate concentrating factor (i.e. 500X), it has been proven that the solar cell efficiency decreases by increasing the cell operating temperature by a factor of 0.005%/°C.

Accordingly, the reduction of the operating temperature for solar cells in CPV systems represents a key aspect for the performances and the efficiency of these cells. In this regard, the receiver device plays a fundamental role in a CPV system since it comprises both the electrically active subsystem (i.e. the PV cell) and the heat spreader. In particular, a point focus-type receiver usually comprises a printed circuit board apt to accommodate a PV cell, the electrical connections and the bypass diode. Also the receiver usually comprises a heat spreader for allowing a heat exchange in a passive way or in an active way (for example by means of a refrigerating fluid flowing in proximity of the cell) as well as a screen system for protecting the cell from possible damaging external atmospheric agents. Commonly, the printed circuit board is fixed to the heat spreader structure (generally metallic) through soldering glues and fixing means using dedicated thermal pastes. The employment of these glues and pastes is in most cases necessary in order to compensate possible differences of the thermal expansion coefficients between the photovoltaic substrate and the receiver itself. As a matter of fact, these connecting layers between the printed circuit board and the heat spreader represent interposing elements that clearly affect the heat exchange between the cell and the external ambient. In addition, it should be taken into account that usually the refrigerating fluid flows into a closed duct having a thickness of about 2.5-5 mmm that further influences the thermal exchange.

US 2013/333746 A1 describes an arrangement and a method for cooling a support having an electronic component, comprising a housing with a base plate, a circumferential wall surrounding the support and a cover extending above the support and closing the interior space of the support.

It is therefore an object of the present invention to provide a receiver device that solves the above mentioned problems. In particular, to provide a receiver device, an optical system, a concentrator device and a concentrating solar photovoltaic system which assure a reliable conversion of the solar energy into electrical and thermal energy.

This object is achieved by the receiver device, the optical system, the concentrator device and the concentrating solar photovoltaic system according to the independent claims.

Further advantageous combinations and designs are given in the dependent claims therefrom.

### DESCRIPTION OF THE INVENTION

The invention consists on a receiver device according to claim 1.

The receiver device according to the present invention is suitable for being integrable in a concentrating solar photovoltaic apparatus for converting solar energy into electrical and thermal energy. Specifically, the receiver device comprises a photovoltaic substrate having an upper surface and a lower surface opposite to the upper surface, the upper surface comprising a photovoltaic device for receiving concentrated solar energy and generating electric current and electrical connectors coupled to the photovoltaic device for conducting the generated electrical current outside the device.

Also, the receiver device according to the present invention comprises a frame element having an upper aperture faced to a lower portion of the concentrating solar photovoltaic apparatus and a lower aperture faced to the upper surface of the photovoltaic substrate as well as a heat regulator element comprising at least a channel for the passage of a refrigerating fluid, the channel communicating with an upper aperture faced to the lower surface of the photovoltaic substrate.

In particular, in assembled configuration, the lower aperture of the frame element is positioned at the upper aperture of the heat regulator element and the photovoltaic substrate is configured to be located between the frame element and the heat regulator element in order hermetically close both the lower aperture of the frame element and the upper aperture of the heat regulator element, the refrigerating fluid being in direct contact with the lower surface of the photovoltaic substrate.

The concentrating solar photovoltaic apparatus in which the receiver device according to the present invention is able to be integrated can be a general optical system comprising an optical member for directing the concentrated solar light to the photovoltaic device of the receiver. In particular, said apparatus can be a concentrator device comprising a focusing optics having an optical lens coupled to the inlet surface of a rigid spacer, wherein the outlet surface of the spacer is connectable to the frame of the receiver. More generally, the concentrating solar photovoltaic apparatus can be a concentrating solar photovoltaic system comprising a plurality of said concentrators.

The expression "integrable in a concentrating solar photovoltaic apparatus" must be intended in this contest that the receiver is attachable and detachable to and from said apparatus through suitable connecting means.

The photovoltaic substrate can be a direct bonded copper (DBC) substrate having an upper surface where is located the PV cell and a lower surface facing the upper aperture of the heat regulator. In this way, the photovoltaic substrate represents the interface element between the frame element and the heat regulator element.

In case the receiver device is integrated in a concentrator device, the DBC of the photovoltaic substrate is configured to assure an electrical insulation resistance greater than 20 MQ with an applied voltage of 3 kV between the contacts of the concentrator device. Also, the DBC is configured to assure an hermetic sealing in case of low/high pressure (0.5 bar) of the gases contained in the concentrator and an hydraulic sealing to the refrigerating fluid for pressures up to 4 bar.

In any case, the DBC of the photovoltaic substrate is configured to assure a direct thermal exchange between the PV cell and the refrigerating fluid without the presence of interposed material layers. In particular, the lower surface of the photovoltaic element is made of a thermally conductive material.

The photovoltaic device is a multijunction solar cell suitably connected to a bypass diode and to the electrical terminations and is fixed to the upper surface of the DBC substrate by means of a soldering paste (i.e. made of Tin).

The electrical connectors comprise electrical terminations (i.e. made of Copper) in order to elastically connect the polarity of the PV cell with electrical pins. The electrical pins are needed in order to lead the generated electrical energy outside the receiver and eventually outside the concentrator. In case the frame of the receiver is made of metallic material, the pins are fixed inside bushings having an electrical insulation resistance greater than 20 MΩ with an applied voltage of 3 kV between the contacts of the concentrator device. In this case, the bushings are configured in such a way to be inserted and fixed in recesses (i.e. holes) present in the frame. The pins, the bushings and the frame are fixed to each other by means of a suitable epoxy glue. In case the frame is made of insulating material, the metallic pins are directly fixed (i.e. glued) inside specific bushings directly provided in the frame.

Alternatively, the electrical connectors may comprise resilient pressure terminations for accommodating the electrical pins. In particular, the connectors can have a S-shaped structure with an upper part provided with an half-open cavity facing upwards apt to favor the insertion of an electrical pin or rod and a lower part provided with a flat surface apt to be fixed to the DBC. This particular configuration makes the assembling and disassembling of the photovoltaic substrate easier, especially when the photovoltaic substrate is placed to close the lower aperture of the frame element passing from the bottom of the frame's aperture.

The frame element can be realized in metallic material (i.e. Aluminum) or insulating material (i.e. ceramic). The upper part of the frame element is configured to be connected to the lower portion of the concentrating solar photovoltaic apparatus by means of a mechanical precision coupling through an auto-centering system having a conical or cylindrical shape. An O-ring can be interposed in order to assure an hermetic sealing between the frame and the concentrating solar photovoltaic apparatus.

The heat regulator element comprises hydraulic connectors with an active flowing refrigerating fluid and a housing having an upper aperture facing the lower aperture of the frame element. The heat regulator element is laterally connected to inlet and outlet tubular structures or pipes for the passage of the refrigerating fluid. The endings of these tubular structures comprise quick connector couplings for the connection to the hydraulic circuit.

With the expression "in assembled configuration" is intended that the frame element, the photovoltaic substrate and the heat regulator element can be assembled together to form the receiver device but also that they can be disassembled in separated components by simply disengaging one element from the others. This is particularly useful in case one of the components needs to be replaced with a different one, for example for maintenance reasons. Additionally, the assembly/disassembly configuration allows the replacement of the PV cell with a new more efficient PV device due for example to a new technological discovery, thereby leading to an efficient upgrading of the entire system.

Summarizing the above, the receiver device according to the present invention allows the conversion of concentrated solar energy (even more than 1000 times) into electric and thermal energy with high efficiency values. Furthermore, the receiver device allows the reduction and the recovery of the heat from the PV device by means of a refrigerating fluid in order to obtain a minimal thermal gradient between the PV device and the fluid. In particular, due to the direct contact between the refrigerating fluid and the lower surface of the photovoltaic substrate, the thermal resistance (number and thickness of the layers) is minimized and the thermal exchange maximized. Finally, the particular structural configuration of the receiver device allows the possibility to easily remove the photovoltaic substrate from the receiver in case of damages, maintenance and/or upgrading of the mechanical and/or electrical components.

According to one embodiment of the present invention, the lower aperture of the frame element defines a two-dimensional surface area having approximatively the same size and dimension of a two-dimensional surface area defined by the upper aperture of the heat regulator element. For example, the surface area of the two apertures can be squared, rectangular, circumferential or of any other suitable shape.

Also, the photovoltaic substrate defines a surface area that is greater than the surface area of the lower aperture of the frame element and of the surface area of the upper aperture of the heat regulator element, respectively.

In this way, once the lower part of the frame element is positioned at the upper part of the heat regulator element, the two corresponding apertures coincide in shape and dimension and the photovoltaic substrate can be sandwiched between these two apertures without the risk that this can pass through one or the other aperture.

In another embodiment of the present invention, the photovoltaic substrate comprises a substrate structure of at least three layers, one insulating layer being interposed between two metallic layers, wherein the refrigerating fluid is in direct contact with one of the metallic layers.

In particular, the upper and lower surfaces are constituted by electrically and thermally conductive materials, intimately connected to the surface of an electrically insulating intermediate layer that is heat resistant and has good thermal conductivity.

More specifically, the photovoltaic substrate comprises a DBC (Direct Bonded Copper) consisting of a thin ceramic layer with high dielectric properties interposed between two sheets of Copper, which are 25-200 µm thick and are soldered to each face of the ceramic layer by means of a high temperature oxidation process in Nitrogen and Oxygen atmosphere.

The ceramic layer can be made of Alumina (Al₂O₃), Aluminum Nitride (AlN) or Beryllium Oxide (BeO). However, the ceramic layer can be made of any material composition suitable for the purpose of this invention for withstanding a high number of thermal cycles, that is having a low coefficient of thermal expansion (close to that of the Silicon).

On the upper surface of the photovoltaic substrate, the electrical paths can be realized by means of a Copper removal process.

The lower surface of the photovoltaic substrate can be flat. However, in a further embodiment of the present invention, the lower surface of the photovoltaic substrate can comprise a plurality of metallic fins in order to increase the surface for the thermal exchange. The fins can be made of high conductive metal, i.e. Copper, and can be soldered on the lower surface of the substrate also made of high conductive metal, i.e. Copper. The fins can be of different shape and dimension and can be mounted according a continuous or discrete path. The soldering can be carried out using the laser welding, the ultrasound welding, or other suitable welding techniques.

In particular, in the assembled configuration, the fins extend through the upper aperture of the heat regulator element. This means that the fins are located in the housing of the heat regulator element and are in direct contact with the refrigerating fluid, thereby assuring a more efficient thermal exchange between the photovoltaic substrate and the heat regulator element.

In a preferable embodiment of the present invention, each electrical connector is configured to be detachable from a corresponding electrical pin associated to an electrical conducting wire. This has the advantage of easily attaching and detaching the photovoltaic substrate by the receiver device in case of necessity, without the need of complicated and time consuming unsoldering procedures.

Specifically, the electrical connector can be a snap-type connector or other type of connectors able to provide the above mentioned detachable/attachable function.

The receiver of the present invention is characterized in that the frame element comprises a recess region in proximity of the lower aperture at an external surface of the frame element in order to accommodate the upper surface of the photovoltaic substrate. In this way, the photovoltaic substrate can be located and inserted between the frame element and the heat regulator element, without occupying any additional space regarding the entire thickness of the receiver device.

Also, the receiver is characterized in that the recess region comprises an abutment border extending along the perimeter of the lower aperture of the frame element abutting against the edge of the photovoltaic substrate and allowing the upper surface of the photovoltaic substrate to extend in part through the lower aperture of the frame element in the assembled configuration.

Specifically, the frame element is fixable to the heat regulator element through connecting means and the photovoltaic substrate is held in position by a compensation of the pressure directed from the heat regulator towards the frame element and an abutment force exerted to the upper surface of the photovoltaic substrate by the abutment border of the frame element.

In other words, the photovoltaic substrate can be assembled upwardly from the lower aperture at an external surface of the frame element in order to close said aperture. The closure may be carried out using an electrically insulating glue (i.e. silicone) or through a mechanical fixing means upon inserting a deformable O-ring between the abutment border of the recess region and the perimeter edge of the photovoltaic substrate. In this way, the perimeter edge of the photovoltaic substrate is mechanically pressed between two deformable materials (i.e. the glue and the O-ring) in order to compensate possible thermal expansions between the photovoltaic substrate and the frame element. Furthermore, the mechanical contrast between the upper perimeter edge of the photovoltaic substrate and the abutment border of the recess region of the frame element allows a compensation of the pressures/forces exerted upwardly on the photovoltaic substrate by both the refrigerating fluid and by the ambient under-pressure formed inside the concentrator.

In another embodiment of the present invention, the heat regulator element comprises a cavity having for example a step-like structure, the cavity being defined by the upper aperture of the heat regulator element. In this way, all structure components present on the lower surface of the photovoltaic substrate, such as the fins, can be easily allocated inside this cavity, without occupying any additional space regarding the entire thickness of the receiver device.

The optical system according to the present invention comprises the receiver device as described above and an optical member for directing the concentrated solar light to the photovoltaic device. The optical member extends here through the upper aperture of the frame element till the proximity of the photovoltaic substrate. In particular, the system comprises a supporting means made of insulating material fixable at the upper aperture of the frame element in order to held in position the optical member and to electrically insulate said optical member from the frame element.

The optical member can represent the secondary optics of a concentrator device. In this way, the optical system according to the present invention is able to support and mechanically fix the secondary optics relative to the photovoltaic device and eventually the primary optics without the risk of electrical discharges.

The concentrator device according to the present invention comprises a focusing optics having at least an optical lens and a rigid spacer with an inlet surface and an outlet surface, wherein the outlet surface has a lower dimension than the inner surface. The optical lens is connected to the inlet surface and the focusing optics is configured to collect solar light from the optical lens and to concentrate the light at the outlet of the spacer. The concentrator also comprises the receiver device or the system as described above, wherein the upper aperture of the frame element is connectable to the outlet of the rigid spacer by means of a reversible, hermetical sealing and self-aligning connecting means including for example an elastic O-ring.

In this way, the connection between the receiver device and the spacer assures an hermetic sealing of the concentrator in case this contains inert gases in overpressure or under-pressure conditions (0.5 bar). Furthermore, the connection between the receiver device and the spacer assures a self-centering (tolerance ± 0.15 mm) and a self-distancing (tolerance ± 0.40 mm) among the components of the concentrator (i.e. the primary optic, the secondary optic and the spacer).

The concentrating solar photovoltaic system according to the present invention comprises a plurality of concentrator devices as describe above, wherein the concentrator devices are arranged and electrically connected in series and/or in parallel on a supporting structure able to automatically follow the movement of the sun.

The project leading to this application has received funding from the European Union's Horizon 2020 research and innovation programme under grant agreement No 674311.

Preferred embodiments of a receiver device in accordance with the invention will be explained herein below in greater detail with reference to the accompanying drawings, in which:
- Fig. 1: shows the components of the receiver device in a disassembled configuration;
- Fig. 2a, 2b, 2c and 2d: show the photovoltaic substrate according to different perspective views from above and from below;
- Fig. 3: shows the frame element according to a perspective view from below;
- Fig. 4a and 4b: show the frame element in assembled configuration with the photovoltaic substrate according to different perspective views from above and from below;
- Fig. 5a and 5b: show the heat regulator element according to different perspective views;
- Fig. 6a and 6b: show the receiver device in assembled configuration according to different perspective views;
- Fig. 7a, 7b and 7c: show the optical member and the optical system in a disassembled configuration;
- Fig. 8a and 8b: show a concentrator device according to an explosion view and in an assembled configuration;
- Fig.9a and 9b: show an electrical connector according to an alternative embodiment of the present invention; and
- Fig 10a and 10b: show the receiver device in assembled configuration comprising the electrical connector of figure 9.

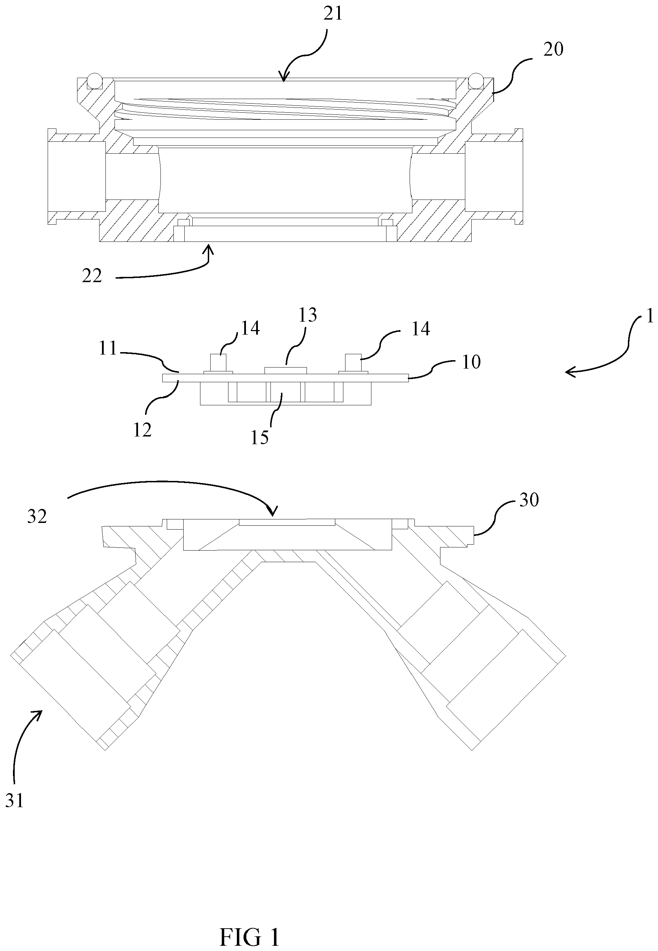

Figure 1 describes, an exploded view of the receiver device 1 according to the present invention in a lateral cross section. The receiver 1 comprises a photovoltaic substrate 10 located between a frame element 20 and a heat regulator element 30. The photovoltaic substrate 10 comprises an upper surface 11 having a high efficiency solar cell 13 and electrical connectors 14 coupled to the cell 13 and a lower surface 12 opposite to the upper surface 11 accommodating a plurality metallic fins 15.

The frame element 20 comprises an upper aperture 21 and a lower aperture 22 (both not shown in the figure), the lower aperture being faced to the upper surface 11 of the photovoltaic substrate 10.

On the other hand, the heat regulator element 30 comprises a channel 31 for the passage of a refrigerating fluid, and an upper aperture 32 communicating with the channel 31 (not shown in the figure). In particular, the upper aperture 32 is faced to the lower surface 12 of the photovoltaic substrate 10.

In assembled configuration, the frame element 20 is connected to the heat regulator element 30 such that lower aperture 22 of the frame element 20 is positioned in correspondence to the upper aperture 32 of the heat regulator element 30 and the photovoltaic substrate 10 is configured to be located between the frame element 20 and the heat regulator element 30 in order to hermetically close by means for example of elastic O-rings both the lower aperture 22 of the frame element 20 and the upper aperture 32 of the heat regulator element 30.According to this configuration, the refrigerating fluid is in direct contact with the lower surface 12 of the photovoltaic substrate 10.

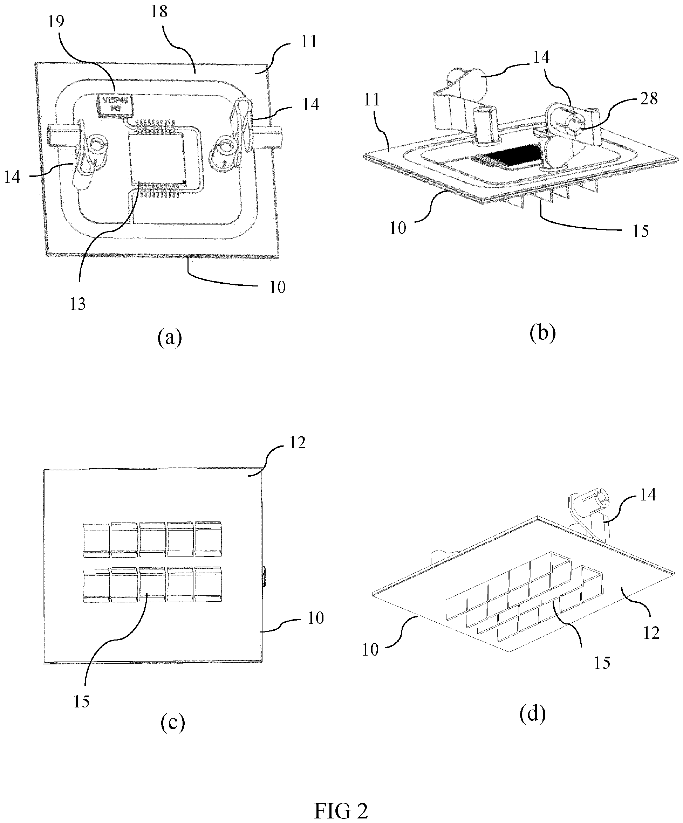

Figures 2a-2d describe the photovoltaic substrate 10 viewed from above (2a and 2b) and from below (2c and 2d). On the upper surface 11 of the photovoltaic substrate 10 are present a solar cell 13, two electrical connectors 14 and a bypass diode 19 for protection. These elements are connected to each other by mans of electrical paths realized on the upper surface 11. In particular, the electrical connectors 14 are located at the border of the photovoltaic substrate 10 and serve to allow the flowing of the generated electrical current outside the receiver 1. From the figure is clear that the connectors 14 are of snap-type, meaning that they each comprise a housing 28 for receiving external elements, such as metallic pins 19 (not shown in the figure), which exactly fit inside the housing 28 with a snap action in order to establish a reliable electrical connection.

Figures 2c and 2d show the presence of metallic fins 15 on the lower surface 12 of the photovoltaic substrate 10. The fins 15 have a C-like profile and are soldered at the central side to the lower surface 12. The fins 15 arranged in rows of two approximately in the center of the surface 12.

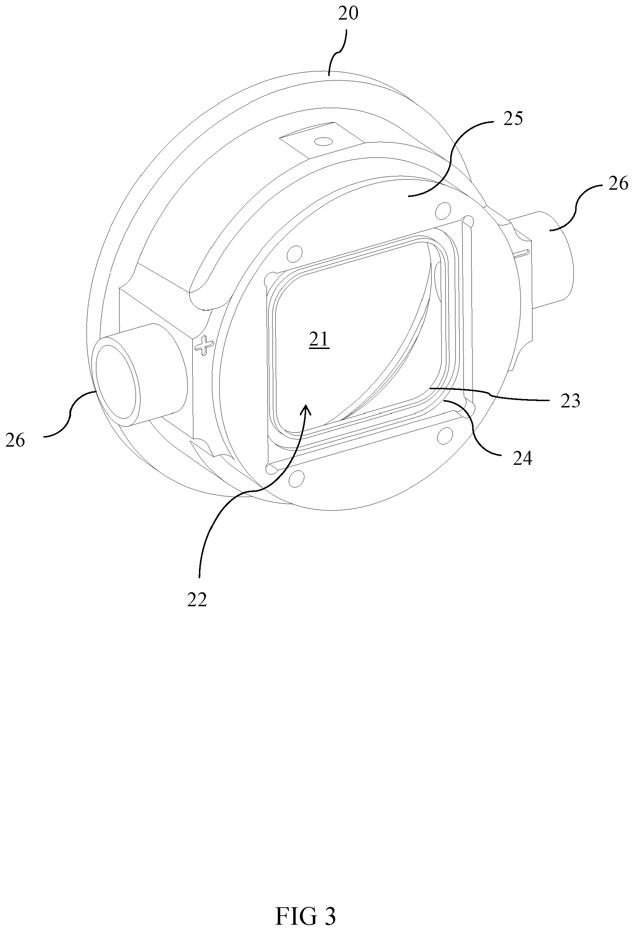

Figure 3 show the frame element 20 in a perspective view from below. The frame element 20 comprises a lower aperture 22 having a squared shape. Through the lower aperture 22 is possible to see the upper aperture 21 having, on the other hand, a circumferential profile.

In proximity of the lower aperture 22 at an external surface 25 of the frame element 20, the frame 20 comprises a recess region 23 in order to accommodate the upper surface 11 of the photovoltaic substrate 10. For this reason, the recess region 23 basically follows the same shape of the photovoltaic substrate 10. In the present case, the recess region 23 has a squared profile.

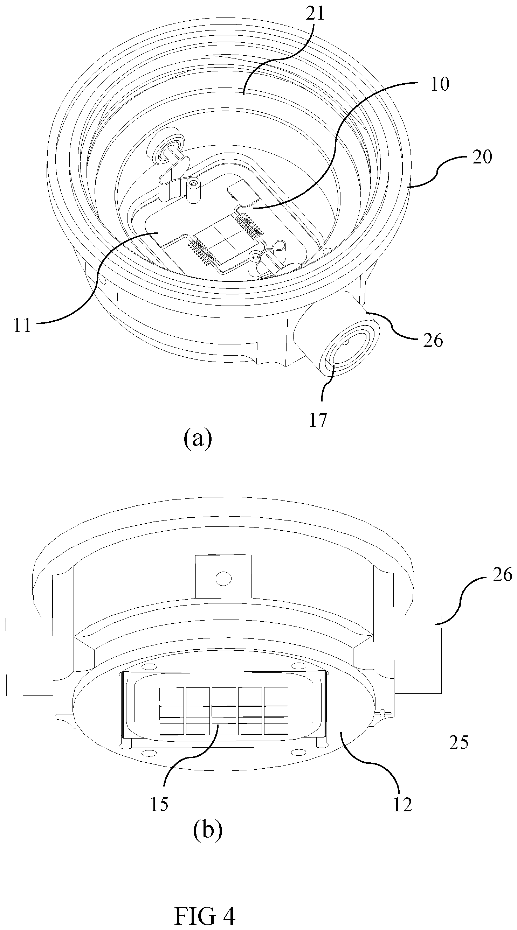

In particular, the recess region 23 comprises an abutment border 24 extending along the perimeter of the lower aperture 22 of the frame element 20 abutting against the edge 18 of the photovoltaic substrate 10 and allowing the upper surface 11 of the photovoltaic substrate 10 to extend in part through the lower aperture 22 of the frame element 20 in the assembled configuration. This is clearly shown in figures 4a and 4b which describe the frame element 20 assembled together with the photovoltaic substrate 10. Here, the photovoltaic substrate 10 completely close the lower aperture 22 of the frame element 20 once the substrate 10 is fitted in the frame 20. It is worth to emphasize that in order to assemble these two components of the receiver 1, the photovoltaic substrate 10 is placed in contact with the frame element 20 from below till the perimeter edge 18 of the upper surface 11 of the photovoltaic substrate 10 abuts against the abutment border 24 of the recess region 23 of the frame element 20. It is noted that the frame element 20 also comprise two lateral housing 26 for accommodating the bushings 17 for the electrical contacts of the photovoltaic substrate 10. Figure 4b shows that when the frame element 20 and the photovoltaic substrate 10 are assembled, the fins 5 extend outside the lower aperture 22 of the frame 20.

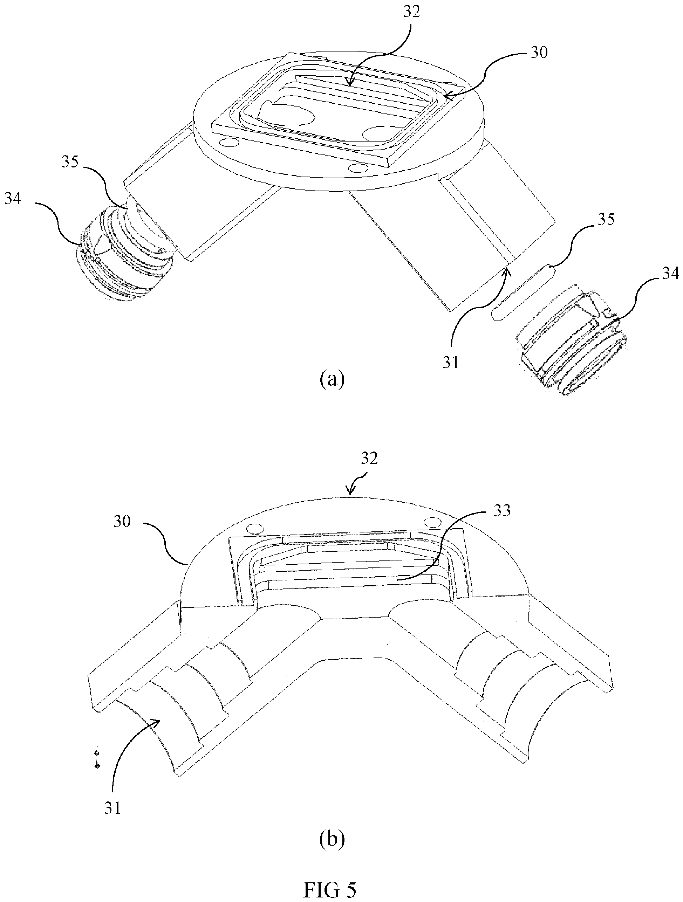

Figure 5a shows the heat regulator element 30 in a lateral perspective view. From the figure it is clear that the heat regulator element 30 comprises an upper aperture 32 having a complementary profile in terms of dimension and shape compared to the lower aperture 22 of the frame element 20 (see figure 3). In particular, the upper aperture 32 has a squared profile with borders and protuberances which match the recess region of the frame element 20 at the external surface 25. The inlet and the outlet of the channel 31 are provided each with an hydraulic joint 34 and an interposed elastic O-ring 35.

Figure 5b is a cross section of the heat regulator element 30 and shows the presence of a cavity 33 having a step-like structure, wherein the cavity 33 is defined by the upper aperture 32. This cavity 33 is apt to receive the metallic fins 15 of the photovoltaic substrate 10 in the assembled configuration and is in fluid communication with the channel 31.

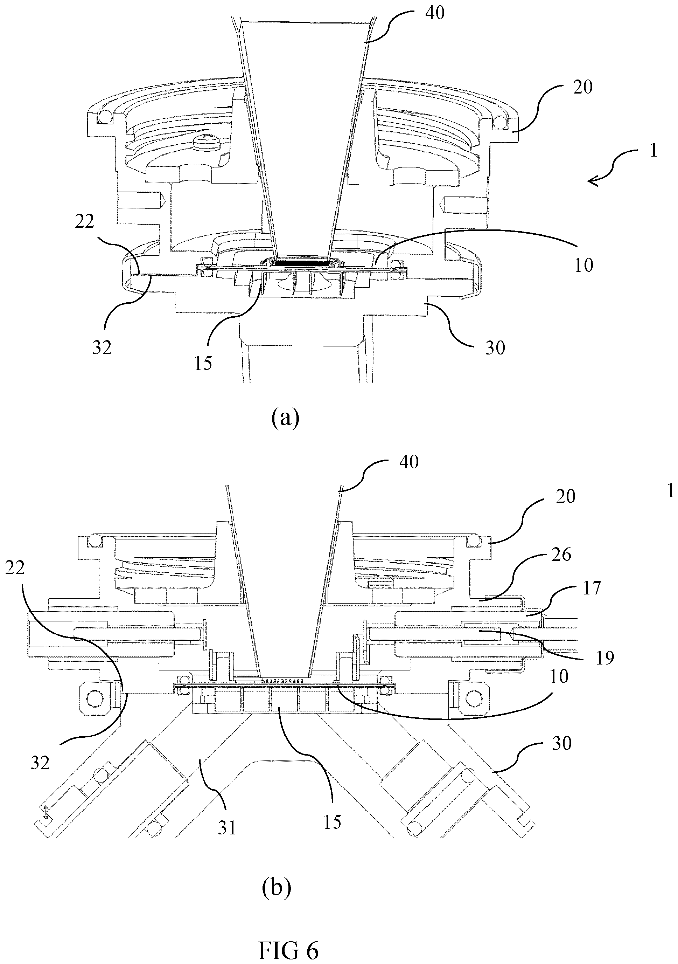

Figures 6a and 6b show the receiver device 1 in the assembled configuration. The frame element 20 is fixed to the heat regulator element 30 and the photovoltaic substrate 10 is placed between these two elements. In particular, the lower aperture 22 of the frame element 20 match the upper aperture 32 of the heat regulator element 30 and the photovoltaic substrate 10 is held in position by a compensation of the pressure directed from the heat regulator element 30 towards the frame element 20 and an abutment force exerted to the upper surface 11 of the photovoltaic substrate 10 by the abutment border 24 of the frame element 20. The figures also show the presence of an optical member 40 that in this case is optionally positioned above the upper surface of 11 the photovoltaic substrate 10 in order to improve the concentration of the light on the solar cell 13.

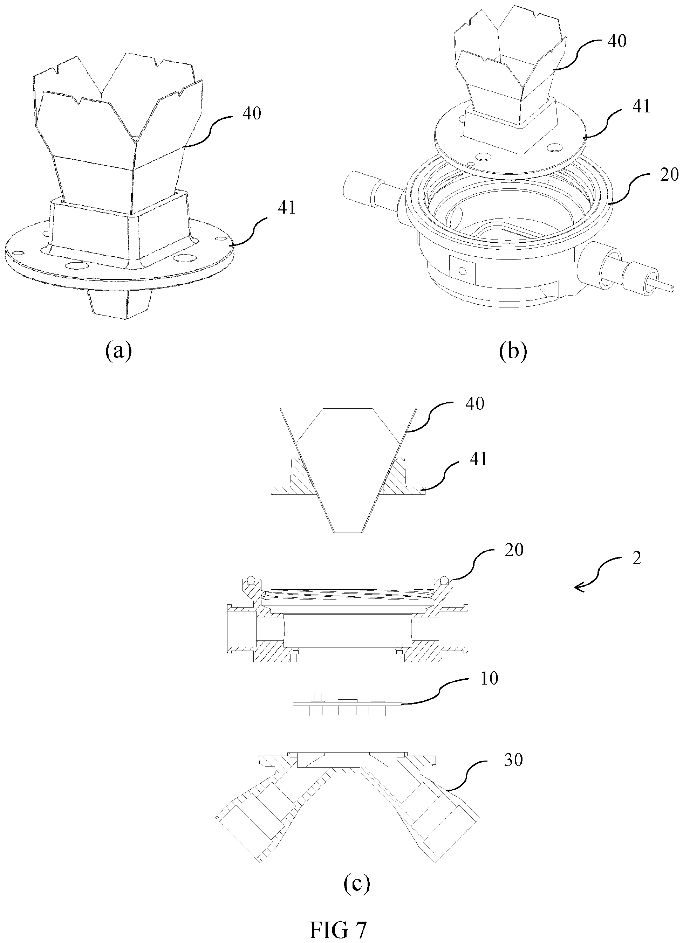

Figure 7a describes an optical member 40 to be placed in proximity of the photovoltaic device 13 of the receiver 1. This optical member can represent the secondary optics used in a concentrator device to homogenize the solar rays so as to lighten the cell 13 uniformly as much as possible, as well as to increase the device acceptance angle. The optical member is constituted by a pyramidal truncated hollow member the wall's tilting therewith will be each time chosen and determined according to the needs and/or circumstances, and the inner surface thereof is highly reflecting so as to convey and homogenizing the light beams onto the underneath cell 13 and so as to further compensate the chromatic aberration.

Figure 7b show the way how to assemble the optical member 40 with the frame element 20. In particular, the optical system 2 is provided with a supporting means 41 made of insulating material, i.e. ceramic or glass, fixable at the upper aperture 21 of the frame element 20 in order to held in position the optical member 40 and to electrically insulate said optical member 40 from the frame element 20.

Figure 7c finally shows the optical system 2 according to the present invention in all the components, that is the optical member 40 fixable to the frame element 20 through the supporting means 41, the frame element 20, the heat regulator element 30 and the photovoltaic substrate 10 placed between the frame element 20 and the heat regulator element 30.

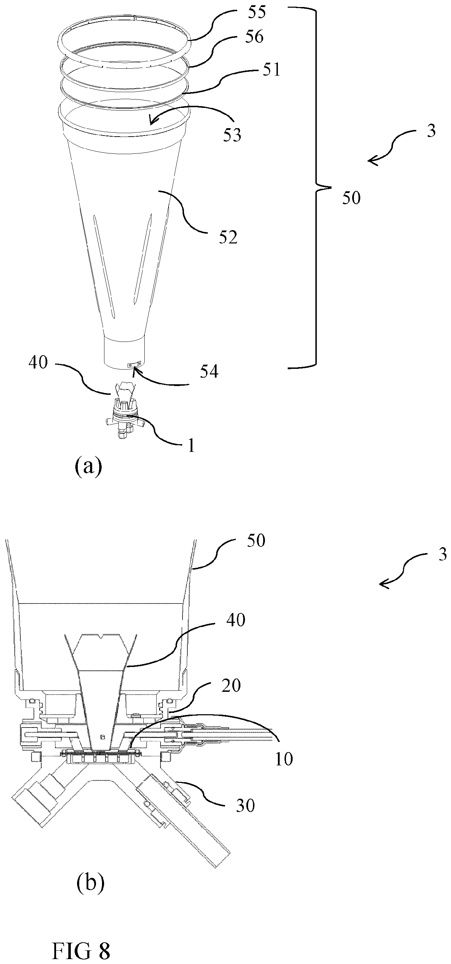

Figures 8a and 8b describe a concentrator device 3 in accordance to the present invention. The concentrator comprises a focusing optics 50 that is connectable to the upper aperture 21 of the frame element 20 of the receiver 1 or the optical system 2 as described above. The concentrator comprises an optical lens 51 (Fresnell or multifocal aspheric glass refractive lens) and a rigid spacer 52 having an inlet surface 53 and an outlet surface 54, wherein the outlet surface 54 has a lower dimension than the inlet surface 53. In particular, the spacer 52 has a conical shape in order to assure the precise positioning and the alignment of the lens related to the receiver 1.

The optical lens 51 is connected to the inlet surface 53 through connecting means (clip 55 and sealing member 56). This connection assures an hermetic closure as well as a self-centering of the entire optics. In particular, the focusing optics 50 is configured to collect solar light from the optical lens 51 and to concentrate the light at the outlet surface 54 of the spacer 52 directly on the receiver 1. In order to avoid condensation and/or oxidation phenomena, the concentrator 3 may contain inert gases (Nitrogen, dry air, etc.) under partial vacuum conditions.

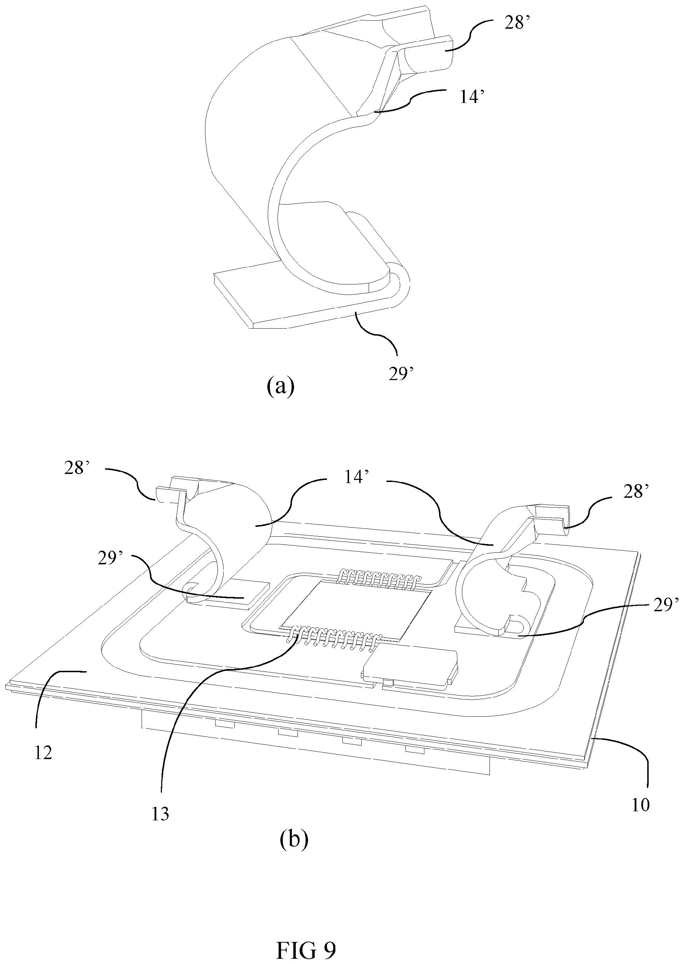

Figure 9a shows an alternative electrical contact 14' having a resilient S-shape structure. The contact 14' comprises an upper portion with a an half-open cavity facing upwards 28' and a lower portion with a flat surface 29'. Figure 9b shows the two connectors 14' mounted to a DBC to form the electrical contacts of a photovoltaic substrate 10. The contacts 14' are mounted by fixing (for example by welding) the flat surface 29' to the upper surface 12 of the photovoltaic device 10.

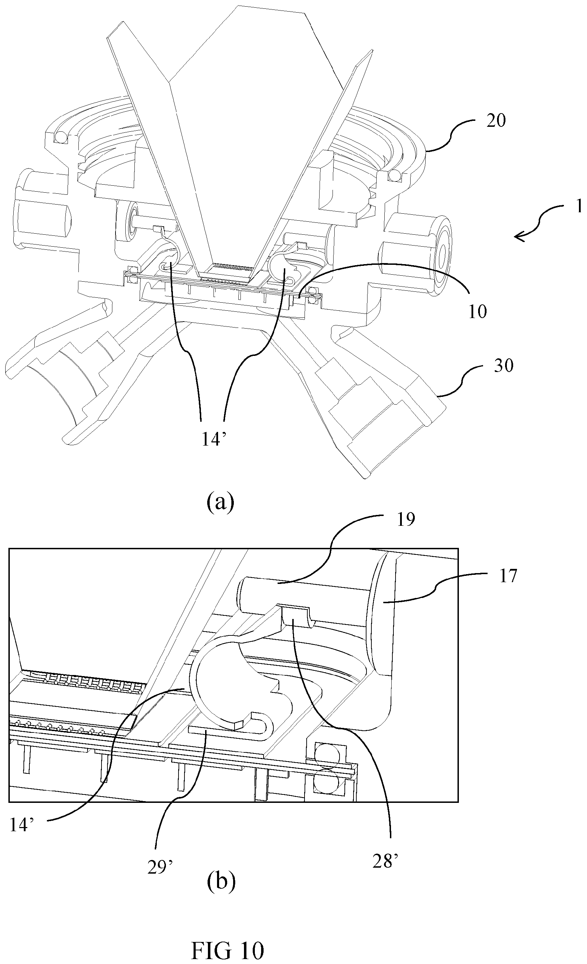

Figure 10a shows the employment of the alternative contact 14' in an assembled receiver and figure 10b shows a detail of figure 10b. From both figures is clear that the cavity 28' is configured to receive the electrical pin 19 and to establish an electrical contact by simply place the pin 19 inside the cavity 28'. The dimension of the cavity 28' can be designed in such a way that the placement of the pin 19 determines an engagement/disengagement of snap-type. The resiliency of the contact 14' assures a reliable electrical contact with the pin 19 by pushing said pin 19 upwards. This alternative embodiment can of course be integrated in any of the embodiments and combination of embodiments described above.

Whilst features have been presented in combination of the above description, this is intended solely as an advantageous combination. The above description is not intended to show required combinations of features, rather it represents each of the aspects of the disclosure. Accordingly, it is not intended that any described specific combination of features is necessary for the functioning of the receiver device, optical system, concentrator device and/or the concentrating solar photovoltaic system.

## Claims

1. Receiver device (1) integrable in a concentrating solar photovoltaic apparatus for converting solar energy into electrical and thermal energy, the device comprising:
a photovoltaic substrate (10) having an upper surface (11) and a lower surface (12) opposite to the upper surface (11), the upper surface (11) comprising a photovoltaic device (13) for receiving concentrated solar energy and generating electric current and electrical connectors (14) coupled to the photovoltaic device (13) for conducting the generated electrical current outside the device (1);
a frame element (20) having an upper aperture (21) faced to a lower portion of the concentrating solar photovoltaic apparatus and a lower aperture (22) faced to the upper surface (11) of the photovoltaic substrate (10); and
a heat regulator element (30) comprising at least a channel (31) for the passage of a refrigerating fluid, the channel (31) communicating with an upper aperture (32) faced to the lower surface (12) of the photovoltaic substrate (10),
wherein in assembled configuration the lower aperture (22) of the frame element (20) is positioned at the upper aperture (32) of the heat regulator element (30) and the photovoltaic substrate (10) is configured to be located between the frame element (20) and the heat regulator element (30) in order hermetically close both the lower aperture (22) of the frame element (20) and the upper aperture (32) of the heat regulator element (30), the refrigerating fluid being in direct contact with the lower surface (12) of the photovoltaic substrate (10)
**characterized in that**
the frame element (20) comprises a recess region (23) in proximity of the lower aperture (22) at an external surface (25) of the frame element (20) in order to accommodate the upper surface (11) of the photovoltaic substrate (10), wherein the recess region (23) comprises an abutment border (24) extending along the perimeter of the lower aperture (22) of the frame element (20) abutting against the edge (18) of the photovoltaic substrate (10) and allowing the upper surface (11) of the photovoltaic substrate (10) to extend in part through the lower aperture (22) of the frame element (20) in the assembled configuration.

2. Receiver device (1) according to claim 1, wherein the lower aperture (22) of the frame element (20) defines a two-dimensional surface area having approximatively the same size and dimension of a two-dimensional surface area defined by the upper aperture (32) of the heat regulator element (30) and wherein the photovoltaic substrate (10) defines a surface area that is greater than the surface area of the lower aperture (22) of the frame element (20) and of the surface area of the upper aperture (32) of the heat regulator element (30), respectively.

3. Receiver device (1) according to any of the preceding claims, wherein the photovoltaic substrate (10) comprises a substrate structure of at least three layers, one insulating layer being interposed between two metallic layers and wherein the refrigerating fluid is in direct contact with one of the metallic layers.

4. Receiver device (1) according to any of the preceding claims, wherein the lower surface (12) of the photovoltaic substrate (10) comprises a plurality of metallic fins (15).

5. Receiver device (1) according to claim 4, wherein in the assembled configuration the fins (15) extend through the upper aperture (32) of the heat regulator element (30).

6. Receiver device (1) according to one of the preceding claims, wherein each electrical connector (14) is configured to be detachable from a corresponding electrical pin (16) associated to an electrical conducting wire.

7. Receiver device (1) according to claim 6, wherein the electrical connector (14) is a snap-type connector.

8. Receiver device (1) according to claim 1, wherein the frame element (20) is fixable to the heat regulator element (30) through connecting means and the photovoltaic substrate (10) is held in position by a compensation of the pressure directed from the heat regulator element (30) towards the frame element (20) and an abutment force exerted to the upper surface (11) of the photovoltaic substrate (10) by the abutment border (24) of the frame element (20).

9. Receiver device (1) according to any of the preceding claims, wherein the heat regulator element (30) comprises a cavity (33) having a step-like structure, the cavity (33) being defined by the upper aperture (32) of the heat regulator element (30).

10. An optical system (2) comprising the receiver device (1) according to any of the preceding claims and an optical member (40) for directing the concentrated solar light to the photovoltaic device (13), the optical member (40) extending through the upper aperture (21) of the frame element (20) till the proximity of the photovoltaic substrate (10), wherein the system (2) comprises a supporting means (41) made of insulating material fixable at the upper aperture (21) of the frame element (20) in order to held in position the optical member (40) and to electrically insulate said optical member (40) from the frame element (20).

11. A concentrator device (3) comprising:
a focusing optics (50) comprising at least an optical lens (51) and a rigid spacer (52) having an inlet surface (53) and an outlet surface (54), wherein the outlet surface (54) has a lower dimension than the inlet surface (53), the optical lens (51) being connected to the inlet surface (53) and the focusing optics (50) being configured to collect solar light from the optical lens (51) and to concentrate the light at the outlet surface (54) of the spacer (52);
the receiver device (1) according to any of the claims comprised between 1 to 9 or the optical system (2) according to claim 10, wherein the upper aperture (21) of the frame element (20) is connectable to the outlet surface (54) of the rigid spacer (52) by means of reversible, hermetical sealing and self-aligning connecting means.

12. A concentrating solar photovoltaic system (4) comprising:
a plurality of concentrator devices (3) according to claim 11, the concentrator devices (3) being arranged and electrically connected in series and/or in parallel on a supporting structure (60) able to automatically follow the movement of the sun.

## Patentansprüche

1. Empfängervorrichtung (1), die in eine konzentrierende Solarphotovoltaikvorrichtung zum Umwandeln von Solarenergie in elektrische Energie und Wärmeenergie integrierbar ist, wobei die Vorrichtung Folgendes umfasst:
ein Photovoltaiksubstrat (10), das eine obere Fläche (11) und eine untere Fläche (12) gegenüber der oberen Fläche (11) aufweist, wobei die obere Fläche (11) eine Photovoltaikvorrichtung (13) zum Empfangen von konzentrierter Solarenergie und Erzeugen von elektrischem Strom und elektrische Stecker (14), die mit der Photovoltaikvorrichtung (13) zum Leiten des erzeugten elektrischen Stroms außerhalb der Vorrichtung (1) gekoppelt sind, umfasst;
ein Rahmenelement (20), das eine obere Öffnung (21), die einem unteren Abschnitt der konzentrierenden Solarphotovoltaikvorrichtung zugewandt ist, und eine untere Öffnung (22), die der oberen Fläche (11) des Photovoltaiksubstrats (10) zugewandt ist, aufweist; und ein Wärmeregulierelement (30), das mindestens einen Kanal (31) für den Durchgang eines Kühlfluids umfasst, wobei der Kanal (31) mit einer oberen Öffnung (32), die der unteren Fläche (12) des Photovoltaiksubstrats (10) zugewandt ist, verbunden ist,
wobei bei der zusammengesetzten Konfiguration die untere Öffnung (22) des Rahmenelements (20) an der oberen Öffnung (32) des Wärmeregulierelements (30) positioniert ist und das Photovoltaiksubstrat (10) konfiguriert ist, um zwischen dem Rahmenelement (20) und dem Wärmeregulierelement (30) zu liegen, um sowohl die untere Öffnung (22) des Rahmenelements (20) als auch die obere Öffnung (32) des Wärmeregulierelements (30) hermetisch zu verschließen, wobei das Kühlfluid in direktem Kontakt mit der unteren Fläche (12) des Photovoltaiksubstrats (10) steht, **dadurch gekennzeichnet, dass**
das Rahmenelement (20) eine Aussparungsregion (23) in der Nähe der unteren Öffnung (22) an einer äußeren Fläche (25) des Rahmenelements (20) umfasst, um die obere Fläche (11) des Photovoltaiksubstrats (10) aufzunehmen, wobei die Aussparungsregion (23) eine Anschlagsgrenze (24) umfasst, die sich entlang des Umfangs der unteren Öffnung (22) des Rahmenelements (20), das an dem Rand (18) des Photovoltaiksubstrats (10) anschlägt, erstreckt, und der oberen Fläche (11) des Photovoltaiksubstrats (10) erlaubt, sich zum Teil durch die untere Öffnung (22) des Rahmenelements (20) in der zusammengesetzten Konfiguration zu erstrecken.

2. Empfängervorrichtung (1) nach Anspruch 1, wobei die untere Öffnung (22) des Rahmenelements (20) einen zweidimensionalen Flächenbereich definiert, der ungefähr dieselbe Größe und Abmessung eines zweidimensionalen Flächenbereichs aufweist, der durch die obere Öffnung (32) des Wärmeregulierelements (30) definiert ist, und wobei das Photovoltaiksubstrat (10) einen Flächenbereich definiert, der jeweils größer als der Flächenbereich der unteren Öffnung (22) des Rahmenelements (20) und des Flächenbereichs der oberen Öffnung (32) des Wärmeregulierelements (30) ist.

3. Empfängervorrichtung (1) nach einem der vorherigen Ansprüche, wobei das Photovoltaiksubstrat (10) eine Substratstruktur aus mindestens drei Schichten umfasst, wobei eine isolierende Schicht zwischen zwei Metallschichten angeordnet ist und wobei das Kühlfluid in direktem Kontakt mit einer der Metallschichten steht.

4. Empfängervorrichtung (1) nach einem der vorherigen Ansprüche, wobei die untere Fläche (12) des Photovoltaiksubstrats (10) eine Vielzahl an Metallfinnen (15) umfasst.

5. Empfängervorrichtung (1) nach Anspruch 4, wobei sich bei der zusammengesetzten Konfiguration die Finnen (15) durch die obere Öffnung (32) des Wärmeregulierelements (30) erstrecken.

6. Empfängervorrichtung (1) nach einem der vorherigen Ansprüche, wobei jeder elektrische Stecker (14) konfiguriert ist, um von einem entsprechenden elektrischen Stift (16) entfernbar zu sein, der mit einem elektrischen leitenden Draht verbunden ist.

7. Empfängervorrichtung (1) nach Anspruch 6, wobei der elektrische Stecker (14) ein Stecker vom Einrasttyp ist.

8. Empfängervorrichtung (1) nach Anspruch 1, wobei das Rahmenelement (20) an dem Wärmeregulierelement (30) durch Verbindungsmittel befestigt werden kann und das Photovoltaiksubstrat (10) durch einen Ausgleich des Drucks, der von dem Wärmeregulierelement (30) zu dem Rahmenelement (20) gerichtet ist, und eine Anschlagkraft, die auf die obere Fläche (11) des Photovoltaiksubstrats (10) durch die Anschlagsgrenze (24) des Rahmenelements (20) ausgeübt wird, in seiner Position gehalten wird.

9. Empfängervorrichtung (1) nach einem der vorherigen Ansprüche, wobei das Wärmeregulierelement (30) einen Hohlraum (33) umfasst, der eine stufenartige Struktur aufweist, wobei der Hohlraum (33) durch die obere Öffnung (32) des Wärmeregulierelements (30) definiert ist.

10. Optisches System (2), das die Empfängervorrichtung (1) nach einem der vorherigen Ansprüche und ein optisches Element (40) zum Ausrichten des konzentrierten Sonnenlichts auf die Photovoltaikvorrichtung (13) umfasst, wobei sich das optische Element (40) durch die obere Öffnung (21) des Rahmenelements (20) bis in die Nähe des Photovoltaiksubstrats (10) erstreckt, wobei das System (2) ein Haltemittel (41) umfasst, das aus isolierendem Material hergestellt ist, das an der oberen Öffnung (21) des Rahmenelements (20) befestigt werden kann, um das optische Element (40) in seiner Position zu halten und das optische Element (40) elektrisch von dem Rahmenelement (20) zu isolieren.

11. Konzentriervorrichtung (3), die Folgendes umfasst:
eine Fokussieroptik (50), die mindestens eine optische Linse (51) und einen starren Abstandshalter (52), der eine Einlassfläche (53) und eine Auslassfläche (54) aufweist, umfasst, wobei die Auslassfläche (54) eine geringere Abmessung als die Einlassfläche (53) aufweist, wobei die optische Linse (51) mit der Einlassfläche (53) verbunden ist und die Fokussieroptik (50) konfiguriert ist, um Sonnenlicht von der optischen Linse (51) zu sammeln und das Licht an der Auslassfläche (54) des Abstandshalters (52) zu konzentrieren;
die Empfängervorrichtung (1) nach einem der Ansprüche 1 bis 9 oder das optische System (2) nach Anspruch 10, wobei die obere Öffnung (21) des Rahmenelements (20) mit der äußeren Fläche (54) des starren Abstandshalters (52) durch reversible, hermetische Dicht- und selbstausrichtende Verbindungsmittel verbindbar ist.

12. Konzentrierendes Solarphotovoltaiksystem (4), das Folgendes umfasst:
eine Vielzahl an Konzentriervorrichtungen (3) nach Anspruch 11, wobei die Konzentriervorrichtungen (3) in Reihe und/oder parallel auf einer Haltestruktur (60) angeordnet und elektrisch verbunden sind, die in der Lage ist, automatisch der Bewegung der Sonne zu folgen.

## Revendications

1. Dispositif récepteur (1) intégrable dans un appareil photovoltaïque solaire à concentration pour convertir de l'énergie solaire en énergie électrique et thermique, le dispositif comprenant :
un substrat photovoltaïque (10) ayant une surface supérieure (11) et une surface inférieure (12) opposée à la surface supérieure (11), la surface supérieure (11) comprenant un dispositif photovoltaïque (13) pour recevoir de l'énergie solaire concentrée et générer un courant électrique, et des connecteurs électriques (14) couplés au dispositif photovoltaïque (13) pour conduire le courant électrique généré hors du dispositif (1) ;
un élément de châssis (20) comportant une ouverture supérieure (21) qui fait face à une portion inférieure de l'appareil photovoltaïque solaire à concentration, et une ouverture inférieure (22) qui fait face à la surface supérieure (11) du substrat photovoltaïque (10) ; et
un élément régulateur de chaleur (30) comprenant au moins un canal (31) pour le passage d'un fluide réfrigérant, le canal (31) communiquant avec une ouverture supérieure (32) qui fait face à la surface inférieure (12) du substrat photovoltaïque (10),
dans lequel, dans une configuration assemblée, l'ouverture inférieure (22) de l'élément de châssis (20) est positionnée à l'ouverture supérieure (32) de l'élément régulateur de chaleur (30), et le substrat photovoltaïque (10) est configuré pour être placé entre l'élément de châssis (20) et l'élément régulateur de chaleur (30) de manière à fermer hermétiquement aussi bien l'ouverture inférieure (22) de l'élément de châssis (20) que l'ouverture supérieure (32) de l'élément régulateur de chaleur (30), le fluide réfrigérant étant en contact direct avec la surface inférieure (12) du substrat photovoltaïque (10),
**caractérisé en ce que** l'élément de châssis (20) comprend une région renfoncée (23) à proximité de l'ouverture inférieure (22) sur une surface externe (25) de l'élément de châssis (20) de manière à recevoir la surface supérieure (11) du substrat photovoltaïque (10), dans lequel la région renfoncée (23) comprend une bordure de butée (24) qui s'étend le long du périmètre de l'ouverture inférieure (22) de l'élément de châssis (20) en venant à butée contre le bord (18) du substrat photovoltaïque (10) et qui permet à la surface supérieure (11) du substrat photovoltaïque (10) de traverser en partie l'ouverture inférieure (22) de l'élément de châssis (20) dans la configuration assemblée.

2. Dispositif récepteur (1) selon la revendication 1, dans lequel l'ouverture inférieure (22) de l'élément de châssis (20) définit une surface bidimensionnelle ayant approximativement la même taille et les mêmes dimensions qu'une surface bidimensionnelle définie par l'ouverture supérieure (32) de l'élément régulateur de chaleur (30), et dans lequel le substrat photovoltaïque (10) définit une surface qui est supérieure à la surface de l'ouverture inférieure (22) de l'élément de châssis (20) et à la surface de l'ouverture supérieure (32) de l'élément régulateur de chaleur (30), respectivement.

3. Dispositif récepteur (1) selon l'une quelconque des revendications précédentes, dans lequel le substrat photovoltaïque (10) comprend une structure de substrat à au moins trois couches, une couche isolante étant interposée entre deux couches métalliques, et dans lequel le fluide réfrigérant est en contact direct avec une des couches métalliques.

4. Dispositif récepteur (1) selon l'une quelconque des revendications précédentes, dans lequel la surface inférieure (12) du substrat photovoltaïque (10) comprend une pluralité d'ailettes métalliques (15).

5. Dispositif récepteur (1) selon la revendication 4 dans lequel, dans la configuration assemblée, les ailettes (15) traversent l'ouverture supérieure (32) de l'élément régulateur de chaleur (30).

6. Dispositif récepteur (1) selon l'une des revendications précédentes, dans lequel chaque connecteur électrique (14) est configuré pour être détachable d'une broche électrique correspondante (16) associée à un fil électrique conducteur.

7. Dispositif récepteur (1) selon la revendication 6, dans lequel le connecteur électrique (14) est un connecteur de type enclipsable.

8. Dispositif récepteur (1) selon la revendication 1, dans lequel l'élément de châssis (20) peut être fixé à l'élément régulateur de chaleur (30) via un moyen de connexion, et le substrat photovoltaïque (10) est maintenu en position par une compensation de la pression dirigée par l'élément régulateur de chaleur (30) vers l'élément de châssis (20) et par une force de butée exercée sur la surface supérieure (11) du substrat photovoltaïque (10) par la bordure de butée (24) de l'élément de châssis (20).

9. Dispositif récepteur (1) selon l'une quelconque des revendications précédentes, dans lequel l'élément régulateur de chaleur (30) comprend une cavité (33) ayant une structure échelonnée, la cavité (33) étant définie par l'ouverture supérieure (32) de l'élément régulateur de chaleur (30).

10. Système optique (2) comprenant le dispositif récepteur (1) selon l'une quelconque des revendications précédentes et un élément optique (40) pour diriger la lumière solaire concentrée vers le dispositif photovoltaïque (13), l'élément optique (40) traversant l'ouverture supérieure (21) de l'élément de châssis (20) jusqu'à proximité du substrat photovoltaïque (10),
dans lequel le système (2) comprend un moyen de support (41) constitué d'un matériau isolant qui peut être fixé à l'ouverture supérieure (21) de l'élément de châssis (20) de manière à maintenir l'élément optique (40) en position et à isoler électriquement ledit élément optique (40) de l'élément de châssis (20) .

11. Dispositif concentrateur (3) comprenant :
un système optique de focalisation (50) comprenant au moins une lentille optique (51) et une entretoise rigide (52) ayant une surface d'entrée (53) et une surface de sortie (54), dans lequel la surface de sortie (54) a une dimension inférieure à celle de la surface d'entrée (53), la lentille optique (51) étant connectée à la surface d'entrée (53), et le système optique de focalisation (50) étant configuré pour collecter la lumière solaire provenant de la lentille optique (51) et pour concentrer la lumière à la surface de sortie (54) de l'entretoise (52) ;
le dispositif récepteur (1) selon l'une quelconque des revendications 1 à 9 ou le système optique (2) selon la revendication 10, dans lequel l'ouverture supérieure (21) de l'élément de châssis (20) est connectable à la surface de sortie (54) de l'entretoise rigide (52) au moyen d'une étanchéité réversible hermétique et d'un moyen de connexion à alignement automatique.

12. Système photovoltaïque solaire à concentration (4), comprenant :
une pluralité de dispositifs concentrateurs (3) selon la revendication 11, les dispositifs concentrateurs (3) étant agencés et connectés électriquement en série et/ou en parallèle sur une structure de support (60) capable de suivre automatiquement le mouvement du soleil.
